Europäisches Patentamt

European Patent Office

Office européen des brevets

(19)

(11) Publication number: **0 462 706 A1**

# EUROPEAN PATENT APPLICATION

(12)

(21) Application number: 91304689.2

(22) Date of filing: 23.05.91

(51) Int. Cl.⁵: **H01R 11/18, H01R 23/72**

(30) Priority: 11.06.90 US 535689

(43) Date of publication of application:
27.12.91 Bulletin 91/52

(84) Designated Contracting States:
DE FR GB

(71) Applicant: ITT INDUSTRIES, INC.
1330 Avenue of the Americas
New York, NY 10019-5490(US)

(72) Inventor: Wilson, Albert Hueal
6517 West 83rd Street
Los Angeles, California 90045(US)

(74) Representative: Vaufrouard, John Charles et
al
RUFFHEAD & VAUFROUARD Maidstone Road
(S.T.C. Site) Foots Cray
Sidcup Kent DA14 5HT(GB)

(54) **Contact assembly.**

(57) A contact apparatus is provided for connecting pairs of terminals of two circuits, which allows terminals to be positioned at high densities with minimum crosstalk, selected impedances, and minimum inductances for fast pulse rise times. The apparatus includes a dielectric frame (30, having multiple miniature cavities (46), and an extendable contact assembly (26) lying in each cavity and having a pair of probes (32,34) projecting from opposite faces of the frame. The two probes of each contact assembly are slideably engaged and are biased apart by a spring (70), the spring being constructed of dielectric material to void inductances and to allow for a high characteristic impedance. The frame can include a body having multiple plated through holes or cavities, and end wall structures having dielectric bushings shorter than the body holes and fitting into the body cavities.

FIG. 2

EP 0 462 706 A1

This invention relates to contact assemblies or apparatus.

Modern high speed, high density circuitry often requires contacts with very close centre-to-centre spacings of less than 0.050 inch. Such close spacing can be achieved by spring probe compression contacts, wherein each contact has a spring biased probe whose tip can press against a conductive pad on a circuit board. U.S. Patent 4,200,351 shows a compression contact wherein a spring-biased plunger projects from one face of a dielectric support to contact a conductive pad on a circuit board.

While compression contacts allow for high densities of contacts, they can create problems. The close spacing of the contacts can lead to crosstalk. Also, if each contact lies close to a grounded shield, the characteristic impedance of the contact may be too low. It may be noted that coaxial cable configurations generally employ three impedance levels: 50, 70, and 93 ohms. Any metal spring around the contact increases its effective diameter and therefore decreases the characteristic impedance. Furthermore, any metal spring can add appreciable inductance to the contact which is detrimental to the transmission of high speed data signals. Many present applications require a pulse rise time of less than 32 picoseconds, which cannot be achieved if there is appreciable inductance. A contact arrangement which allowed close spacing of contacts, while minimising crosstalk, minimising inductance, and allowing control of impedance especially to allow for relatively high impedance, would be of considerable value.

In accordance with one embodiment of the present invention, a contact apparatus is provided to facilitate high contact densities, while minimising crosstalk and inductances, and which can facilitate control of impedance. The apparatus can include a frame of dielectric material having a plurality of cavities that each hold an extendable contact assembly. Each contact assembly includes at least one probe projecting through a hole in the frame to project from a face of the frame, the probe being deflectable when a contact pad is pressed thereagainst. A spring device that biases the probe is preferably formed of dielectric material to minimise inductance and allow for a small diameter contact assembly. The contact assembly can include two probes with tips that project from opposite faces of the frame, with the two probes being permanently slideably engaged.

The contact apparatus can include a body with plated-through holes and end wall structure with bushing portions that fit into the holes. The length and dielectric constant of the bushing portions can control the characteristic impedance of each coaxial conductor formed by a contact assembly in the hole and the grounded plating that lines the hole.

By way of example various embodiments of the present invention will now be described with reference to the accompanying drawings, in which:

Figure 1 is an exploded perspective view of a circuit assembly which includes a compression contact apparatus according to the present invention and a pair of circuit boards that can be interconnected through the apparatus;

Figure 2 is a sectional view of the compression contact apparatus of Figure 1, showing two contact assemblies, with one in an uncompressed state and the other in a fully compressed state;

Figure 3 is a plan view of the compression contact apparatus of Figure 1, with a portion as seen on line 3-3 of Figure 2 and another portion as seen with the upper wall of Figure 2 removed;

Figure 4 is a partial sectional view of another contact apparatus with another form of spring device;

Figure 5 is a partial section view of contact apparatus with still another form of spring device;

Figure 6 is a sectional view of a contact assembly constructed in accordance with another embodiment of the invention; and,

Figure 7 is a partial perspective exploded view of the assembly of Figure 6.

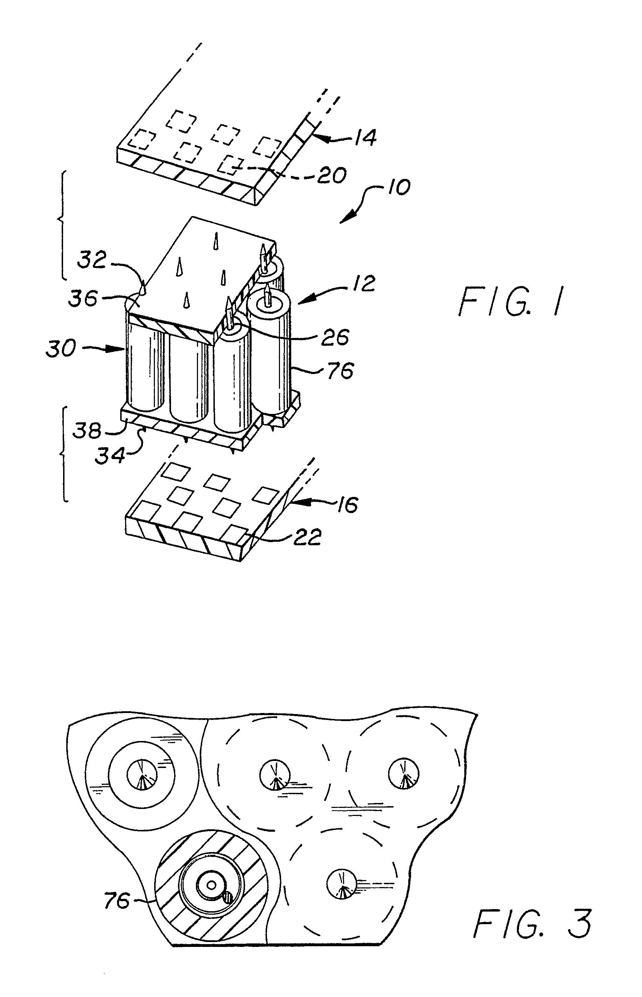

Referring now to the drawings, Figure 1 illustrates a circuit assembly 10 which includes a compression contact apparatus 12 according to the present invention which can be used to interconnect a pair of electrical circuits such as those on a pair of circuit boards 14,16. The first circuit board 14 has terminals or contact pads 20 which are to be connected to corresponding pads 22 on the other circuit board. The contact apparatus 12 has numerous contact assemblies 26 that can interconnect pairs of corresponding pads 20,22. Each contact assembly 26 lies in a dielectric frame 30 and has a pair of probes 32,34 projecting from opposite faces 36,38 of the frame.

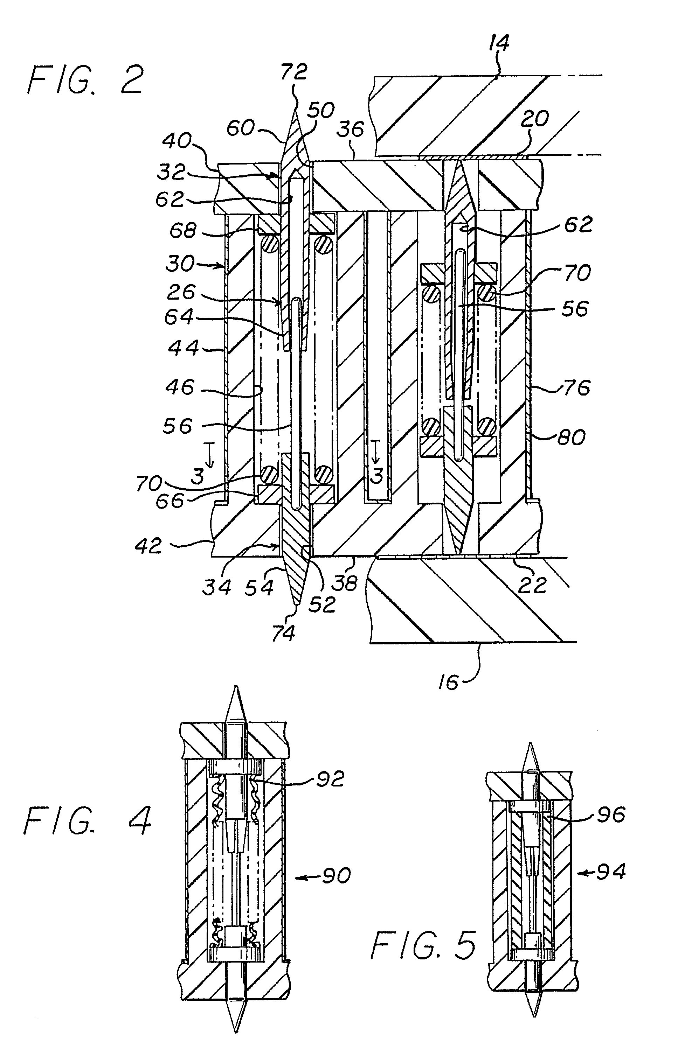

As shown in Figure 2, the frame 30 has first and second end walls 40.42 and has side walls 44 extending between the end walls. The frame forms multiple cavities 46 between the walls, with each contact assembly 26 lying largely in one of the cavities. The end walls 40,42 each has multiple holes 50,52, and the probes 32,34 project from the cavity through corresponding holes in the end walls, and initially beyond the opposite faces 36,38 of the frame.

The second probe 34 of each contact assembly includes a lower or outer portion 54 and an upwardly extending pin portion 56. It should be noted that the terms "lower", "upwardly", etc. refer to parts as illustrated, but not necessarily to their orientation in actual use. The first probe 32 includes an upper or outer portion 60 which has a bore 62 that slideably receives the pin portion 56 of the other probe. The bottom or inner portion 64 of the first probe forms fingers that resiliently engage the pin portion 56 to maintain electrical contact between the two probes 32,34 as they telescope, or slide together and apart.

Each probe has a flange 66,68 fixed to the rest of the corresponding probe. A spring device 70, shown here as a coil spring, extends between the flanges of the two probes. The spring is preloaded in compression, so it constantly urges the tips 72,74 of the probes away from each other and outward from a corresponding face of the frame.

When the two circuit boards 14,16 are pressed against the opposite faces 36,38 of the frame, they deflect the probe tips inwardly until they lie substantially flush with the faces of the frame, with the tips of the probes contacting the conductive pads 20,22 on the circuit boards. In this way, the pads 20,22 of the circuit boards are interconnected. During inward movement of the probes, the spring 70 is compressed and the pin portion 56 of the lower probe slides more deeply into the bore 62 of the upper probe.

The use of compression contacts allows the contact assemblies to lie close together. This can lead to crosstalk between adjacent contacts. To minimise such crosstalk, the side walls 44 are formed to provide a separate side enclosure 76 around each contact assembly, and the outside of each side enclosure are plated with a plating 80 of conductive material. Inasmuch as the plating around all contact assemblies are at the same potential, such as ground, they are interconnected. The plating is connected to a ground terminal of one or both of the circuit boards through a contact (not shown).

Where the contact assemblies carry high frequencies or pulses with short rise times (current rise times are often less than 32 picoseconds) it is important that each contact assembly have minimum inductance, inasmuch as inductance tends to filter out higher frequencies and increase the rise time of pulses. A potential source of high inductance is the coil spring 70. The introduction of inductance from the coil spring 70 is avoided by constructing the spring of dielectric material, such as Nylon. By avoiding the presence of a long and large diameter electrically conductive element in the contact assembly, a contact assembly of small equivalent outside diameter is produced, the equivalent outside diameter being somewhere between the outside diameter of the pin portion 56 and of the outer portions 54,60 of the probes.

It is often desirable to establish a controlled characteristic impedance for each contact assembly. Coaxial impedance cables generally have an impedance of 50,70, or 93 ohms, and it is often desirable to match the characteristic impedance of the contact assemblies to that of coaxial conductors on the circuit boards. The characteristic impedance of a contact assembly may be lower than desired. The impedance can be increased by increasing the distance between the centre conductor, formed by the contact assembly 26, the outer conductor formed by the plating layer 80 surrounding it. By avoiding a spring of electrically conductive material, applicant produces a contact assembly of small equivalent outside diameter, to enable a higher characteristic impedance to be produced. It is possible to construct the flanges 66,68 that are attached to the probes, of dielectric material, to further decrease the equivalent outside diameter of each contact assembly.

Figure 4 illustrates another compression contact apparatus 90 that is similar to that of Figures 1-3, except that it uses a spring device 92 formed by a bellows of dielectric material, such as Nylon.

Figure 5 is a view of still another contact apparatus 92, which is similar to that of Figures 1-3, except that its spring device 96 is formed by a tube of elastomeric material, such as rubber.

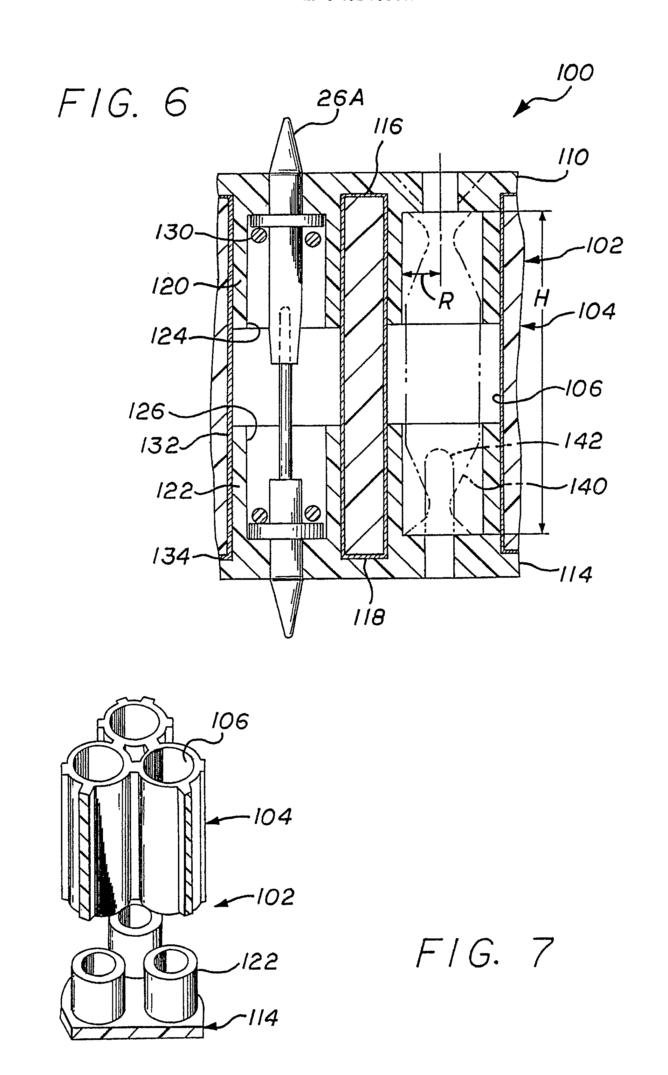

Figure 6 illustrates another contact apparatus 100 which includes a frame 102 that can hold contact assemblies, such as a pressure contact assembly 26A, that is similar to that of Figures 1-5. The frame 102 includes a body 104 with multiple through holes or cavities 106. Two end wall structures 110,114 lie against the opposite faces 116, 118 of the body. Each end wall structure includes bushing portions 120, 122 that fit into the cavities 106. For the pressure contact assembly 26A, the bushing portions form holes 124,126 that receive end portions of a dielectric spring 130 to control the position of the spring.

Each cavity 106 has an internal surface portion 132 formed of metal, which can be achieved by moulding the body 104 of plastic and plating it. The surface portions 132 of some or all of the cavities are interconnected, as by extending the plating as at 134 to interconnect the plating portions at the insides of different cavities. The plating is at a controlled potential, such as ground. This forms a coaxial conductor at each contact assembly, with the metal surface portion or plating 132 forming the grounded outer conductor and the contact assembly such as 26A forming the inner conductor.

It is often important to construct coaxial cables and connectors so they have a predetermined impedance that matches the impedance of other parts of a circuit connected to it. The use of bushing portions 120,122 that lie between the contact assembly such as 26A and the grounded plating 132 enables close control of the characteristic impedance of each coaxial connector formed by a contact assembly 26A and a grounded layer 132. This is because the characteristic impedance of a coaxial conductor is dependent on the material between its conductors. Specifically, the characteristic impedance is proportional to the inverse of the square root of the dielectric constant of material between the inner and outer coaxial conductors. Where a high characteristic impedance is desired, the bushing portions 120, 122 can be of material of low dielectric constant, and can be short so that almost the entire volume between the inner and outer conductors is filled with air. Where a low characteristic impedance is desired, the bushing portions 120,122 can be long so their combined length is almost equal to the length of the holes 106, and the bushing portions can be formed of material of high dielectric constant.

The strength of the contact assembly frame 102 is primarily in the body 104, so the end wall structures 110,114 and their bushing portions can be constructed of low strength material. It may be noted that the body 104 can be constructed entirely of metal, although it is generally easier to form it of moulded plastic and to plate the plastic.

Although the pressure contact assemblies 26A can be used in the frame 102, the frame can also be used to hold other contact assemblies, such as that illustrated in chain line outline at 140 which is designed to receive a pin contact, such as that illustrated at 142.

Thus, the invention provides a contact apparatus which is of simple construction and which has minimal inductance. The apparatus can include compression contact assemblies lying in cavities of a frame, with each contact assembly having at least one probe tip projecting from as face of the frame but being resiliently depressible inwardly. A spring that biases the probe outwardly, is formed of dielectric material. Each contact assembly can include two probes projecting from holes in opposite end walls of the frame and with the probes in permanent sliding contact with each other. A variety of dielectric spring devices can be used to outwardly bias the probes, including a coil spring, a bellows, a tube of elastomeric material, or a collapsing hourglass shape. The frame can include a body with plated cavities, and end wall structures having bushings that project into the cavities and control the characteristic impedance.

## Claims

1. A compression contact apparatus including a frame (30;102) of dielectric material having first and second end walls (40,42:10,114) with a plurality of cavities (46:106) being provided between the end walls and with a plurality of holes (50,52) in each end wall extending into one of the cavities, an extendable contact assembly (26:26A) lying in each of a plurality of the cavities with each contact assembly including a pair of probes (32,34) projecting through holes at opposite ends of the appertaining cavity, and a spring device (70:92:96:130) in the appertaining cavity which urges the pair of probes apart, characterised in that the spring device (70:92:96:130) is constructed of dielectric material.

2. An apparatus as claimed in claim 1, characterised in that a first probe (32) has walls forming a bore (62) with an opening in one end thereof which is closest to a second probe (34), and the second probe has a pin (56) slideably received in the first probe bore and in that the first and second probes each have a flange (66,68) lying in the cavity 46 with the spring device (70) lying about the pin and having opposite ends thereof bearing against the flanges.

3. An apparatus as claimed in claim 1 or 2, characterised in that the end walls (40,42) each have an outer face (36,38) and the probes each have a tip (72,74) and in that first and second circuit boards (14,16) are provided, each having a plurality of conductive pads (20,22) and each lying facewise substantially against the first and second end wall faces (36,38), with the probes lying against the contact pads and with the tips lying substantially flush with the end wall faces (36,38).

4. An apparatus as claimed in any preceding claim, characterised in that the or each spring device is formed of a tube (96) of elastomeric material.

5. An apparatus as claimed in any preceding claim, characterised in that the frame (30) includes a plurality of side enclosures (76) projecting from the second end wall (42), each side enclosure surrounding one of the contact assemblies (26) and the side enclosures being spaced apart and in that conductive material (80) covers the outside of each side enclosure (76).

6. Compression contact apparatus for connecting pairs of conductive pads on two circuit boards or the like, characterised by a frame (30,102) of dielectric material having parallel first and second opposite faces (36,38), a plurality of contact assemblies (26,26A) each having first and second probes (32,34) with tips (72,74) projecting from opposite faces but being moveable into a corresponding frame face by a conductive pad (20,22) pressed towards the corresponding frame face and being moveable out of the corresponding frame face, the first probe (32) having a bore in an end opposite its tip, and the second probe (34) having a pin (56) portion slideably received in the bore of the first probe and by a spring device (70,92,96) biasing the first and second probes of each contact assembly to urge their tips out of corresponding frame face.

7. An apparatus as claimed in claim 6, characterised in that the spring device (70,92,96,130) of each contact assembly is constructed of dielectric material.

8. Contact apparatus characterised by a frame (102) which includes a body (104) having a face and a plurality of cavities (106) extending into the face, and at least one wall structure (110,114) lying over the face and having a plurality of apertures for passing contacts, the wall structure including a plurality of bushing portions (120,122) projecting into the cavities (106), by a plurality of contact assemblies (26A), each lying in one of the cavities which have walls (132) of electrically conductive material connected together.

9. An apparatus as claimed in claim 8, characterised in that the body (104) has a predetermined thickness and the cavities (106) extend through the entire thickness of the body, in that the body has first and second faces and in that the frame (102) includes a second wall structure lying over the second body face and has apertures and bushing portions (120,122) projecting into the cavities (106).

10. An apparatus as claimed in any preceding claim, characterised in that the cavities of the frame are adapted to receive pin receiving contact assemblies (140).

FIG. 1

FIG. 3

FIG. 2

FIG. 4

FIG. 5

FIG. 6

FIG. 7

European
Patent Office

**EUROPEAN SEARCH
REPORT**

Application Number

**EP 91 30 4689**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | EP-A-0 248 521   (PLESSEY OVERSEAS) <br> * column 1, lines 1-31; column 2, lines 13-24; figures 1,2 * | 6 | H 01 R 11/18 <br> H 01 R 23/72 |
| A |  | 1,3 | |
| A | GB-A-2 166 913   (TEKTRONIX) <br> * page 1, lines 26-51,87-92; figure 2 * | 1 | |
| A | DE-A-3 500 227   (RIBA-PRÜFTECHNIK) <br> * page 7, paragraphs 2-4; figure 1 * | 1-3,6 | |
| Y | EP-A-0 197 637   (QA TECHNOLOGY) <br> * column 2, lines 32-48; figure 4 * | 6 | |
| A |  | 1,2 | |

|  |  |  | TECHNICAL FIELDS SEARCHED (Int. Cl.5) |
|---|---|---|---|
|  |  |  | H 01 R 11/00 <br> H 01 R 9/00 <br> H 01 R 13/00 <br> H 01 R 23/00 |

The present search report has been drawn up for all claims

| Place of search | Date of completion of search | Examiner |
|---|---|---|
| Berlin | 18 September 91 | ALEXATOS G |

CATEGORY OF CITED DOCUMENTS

X : particularly relevant if taken alone
Y : particularly relevant if combined with another
   document of the same catagory
A : technological background
O : non-written disclosure
P : intermediate document
T : theory or principle underlying the invention

E : earlier patent document, but published on, or after
   the filing date
D : document cited in the application
L : document cited for other reasons

                              

& : member of the same patent family, corresponding
   document